# EUROPÄISCHE PATENTSCHRIFT

(11) **EP 2 375 543 B1**
(45) Veröffentlichungstag und Bekanntmachung des Hinweises auf die Patenterteilung: **26.06.2019**
(21) Anmeldenummer: 10003792.8
(22) Anmeldetag: 08.04.2010
(51) Int. Cl.: H02J 13/00, G01R 15/14, H02G 1/02, H04B 3/54, H04L 1/08

(54) **Verfahren zur Überwachung einer Energieübertragungsleitung, Störunterdrückung durch wiederholte Datenübertragung**
Method for monitoring an energy transmission line, noise suppression by repeated data transmission
Procédé de surveillance d'une ligne de transport d'énergie, suppression de bruit par transmission répété de données

(43) Veröffentlichungstag der Anmeldung: 12.10.2011
(73) Patentinhaber: Omicron electronics GmbH, 6833 Klaus (AT)
(72) Erfinder: Klapper, Ulrich, 6830 Rankweil (AT)
(74) Vertreter: Banzer, Hans-Jörg

(56) Entgegenhaltungen:
- WO-A1-2007/031435
- CA-C- 2 215 380
- US-A- 4 158 810
- US-A1- 2008 084 937

## Beschreibung

Die vorliegende Erfindung betrifft ein Verfahren und ein System zur Überwachung einer Energieübertragungsleitung, wobei insbesondere entlang der Energieübertragungsleitung Messgrößen erfasst werden.

Um einen zuverlässigen Betrieb von Energieübertragungsleitungen, wie z.B. Hochspannungsfreileitungen, Mittelspannungsfreileitungen, Hochspannungskabeln oder Mittelspannungskabeln, sicherzustellen, werden herkömmlicherweise Glasfasern in die Kabel oder Leitungen eingebracht, um eine Temperaturmessung der Leitungen bzw. Kabel durchzuführen. Dabei werden die physikalischen Eigenschaften der Glasfaser überwacht. Durch diese Art der Überwachung entstehen jedoch hohe Kosten durch die Verwendung der Glasfasern. Darüber hinaus kann mit Hilfe der Glasfaser lediglich die Temperatur überwacht werden, wohingegen eine ebenfalls wünschenswerte Überwachung weiterer Parameter, beispielsweise von Teilentladungen oder Durchhänge von Freileitungen, nicht möglich ist.

Aus der Druckschrift US 2008/0084937 A1 ist in diesem Zusammenhang ein System bekannt, welches zugeordnete Geräte zur Übertragung von Funkfrequenzenergieleitungsträgersignalen auf Hochspannungswechsel- oder Gleichstromübertragungsleitungen innerhalb eines Mehrfachleiterbündels aufweist.

Aus der Druckschrift 2007/031435 A1 ist eine Vorrichtung zur Echtzeitüberwachung von Energiefreileitungen bekannt. Die Vorrichtung umfasst ein Überwachungsteilsystem zum Überwachen von zumindest mechanischen Parametern der Energiefreileitung und ein Kommunikationssystem zum Übertragen der von dem Überwachungsteilsystem erzeugten Überwachungsinformation.

US 4,158,810 betrifft eine Fernmessstütze zum Messen von Variablen in einer Hochspannungsfreileitung. Ein oder mehrere Sensoren, welche einen Leiter einer Hochspannungsfreileitung kontaktieren, stellen Signale zum Messen von Variablen bereit, welche dem Betrieb einer Hochspannungsfreileitung zugeordnet sind, wie z.B. Spannung, Strom oder Phase, Drahttemperatur, Umgebungsionisierung usw. Diese Signale werden von einem Analog/Digitalwandler in Daten umgewandelt, welche aufgenommen werden, um Meldungen über einen Betriebszustand einer Hochspannungsfreileitung zu bilden, welche als digitale Telegramme drahtlos zu einem abgesetzten Punkt gesendet werden.

CA 2 215 380 C betrifft ein Verfahren und eine Vorrichtung für eine Datenkodierung und Datenübertragung über ein verrauschtes Medium. Eine Art eines Fehlerkorrekturschemas, welches üblicherweise bei Datenkommunikationssystemen verwendet wird, ist die Verwendung von redundanten Datenübertragungen und einem Abstimmungsschaltkreis an dem Empfangsort. Bei einem derartigen System werden die Daten eine Anzahl von Malen wiederholt übertragen. Bei dem Empfangsort werden alle Datenblöcke empfangen und von einem Abstimmungsschaltkreis verarbeitet, welcher alle empfangenen Versionen von jedem Datenbit vergleicht und auf der Grundlage der Abstimmung bestimmt, ob das Bit eine 1 oder eine 0 ist.

Aufgabe der vorliegenden Erfindung ist es, ein verbessertes und kostengünstigeres Verfahren zur Überwachung von Energieübertragungsleitungen bereitzustellen.

Diese Aufgabe wird gemäß der vorliegenden Erfindung durch ein Verfahren zur Überwachung einer Energieübertragungsleitung nach Anspruch 1 und ein System zur Überwachung einer Energieübertragungsleitung nach Anspruch 5 gelöst. Die abhängigen Ansprüche definieren bevorzugte und vorteilhafte Ausführungsformen der Erfindung.

Gemäß der vorliegenden Erfindung wird ein Verfahren zur Überwachung einer Energieübertragungsleitung bereitgestellt. Bei dem Verfahren werden Messdaten an einer Messstelle der Energieübertragungsleitung mit einer Messvorrichtung erfasst. Die erfassten Messdaten werden auf die Energieübertragungsleitung eingekoppelt und über die Energieübertragungsleitung zu einer Messdatenerfassungsvorrichtung übertragen. Die Messdaten können beispielsweise Messgrößen der Energieübertragungsleitung umfassen, wie z.B. eine Temperaturinformation der Energieübertragungsleitung, Teilentladungsinformationen der Energieübertragungsleitung, aber auch Informationen über den Durchhang von Freileitungen oder einen Abstand zwischen Leitern von Freileitungen und dem Boden. Der Durchhang und der Abstand zwischen Leiter und Boden kann beispielsweise indirekt über eine Kraftmessung einer Leiterspannkraft ermittelt werden. Die übertragenen Messdaten können an einer Messdatenerfassungsvorrichtung zur Auswertung der Messdaten aus der Energieübertragungsleitung ausgekoppelt werden.

Indem die Messdaten an einer Messstelle der Energieübertragungsleitung erfasst werden und über die Energieübertragungsleitung zur Auswertung zu der Messdatenerfassungsvorrichtung übertragen werden, ist eine Verwendung einer in die Energieübertragungsleitung eingebrachten Glasfaser zur Temperaturmessung nicht erforderlich, wodurch die erheblichen Kosten für die Glasfaser eingespart werden können. Darüber hinaus ist es möglich, mit der Messvorrichtung neben der Temperaturinformation auch weitere Parameter, wie z.B. eine Teilentladungsinformation eines Abschnitts der Energieübertragungsleitung, zu erfassen und zur Auswertung zu der Messdatenerfassungsvorrichtung über die Energieübertragungsleitung zu übertragen. Das Einkoppeln der Messdaten kann insbesondere an Hochspannungskabeln beispielsweise an einer Stelle erfolgen, an welcher die Leiter eines Dreiphasensystems gekreuzt sind. Die Messdaten können beispielsweise für einen Leiter, einen Schirm oder für mehrere von einer gemeinsamen Hülle umgebene Leiter gemeinsam erfasst und übertragen werden.

Gemäß einer Ausführungsform werden die Messdaten elektrisch auf die Energieübertragungsleitung eingekoppelt. Die Messdaten können beispielsweise induktiv auf die Energieübertragungsleitung eingekoppelt werden oder beispielsweise zwischen einem Schirm und einem Innenleiter einer koaxial aufgebauten Energieübertragungsleitung eingekoppelt werden. Die Erfassung und Einkopplung der Messdaten zwischen Schirm und Innenleiter kann bei Hoch- oder Mittelspannungskabeln insbesondere bei so genannten Cross-Bonding-Boxen erfolgen, da dort besonders häufig potentielle Fehlerquellen vorhanden sind und dort die Schirme der drei Phasen ausgekreuzt werden, wodurch die einfache Möglichkeit besteht, die Messdaten zwischen Schirm und Innenleiter oder auf einen der beiden einzukoppeln.

Weiterhin können die Messdaten über einen oder mehrere Schirme und Innenleiter gemeinsam auf die Energieübertragungsleitung eingekoppelt werden. Bei dieser sogenannten Gleichtakteinkopplung oder Common-Mode-Einkopplung werden die Messdaten über das gesamte Kabel einschließlich Schirm und Innenleiter und möglicherweise sogar über alle drei Phasen eingekoppelt. Daher können Messdaten auch an Stellen eingekoppelt werden, bei denen Schirm und/oder Innenleiter nicht separat zugänglich sind. Auf diese Art und Weise kann beispielsweise jede Muffe eines Kabels temperatur- oder teilentladungsüberwacht werden.

Die Messdaten werden mehrfach wiederholt von der Messvorrichtung zu der Messdatenerfassungsvorrichtung übertragen. In der Messdatenerfassungsvorrichtung werden die mehrfach wiederholten Messdaten überlagert. Wird das Messsignal sehr oft wiederholt übertragen und von der Messdatenerfassungsvorrichtung empfangen, kann diese Wiederholung von der Messdatenerfassungsvorrichtung zur Mittelung genutzt werden. Wenn die Wiederholungsrate und das Zeitverhalten der Wiederholung der Messdaten bekannt ist, kann durch eine Überlagerung eine Mittelung der Messdaten durchgeführt werden, wodurch eine sehr gute Störunterdrückung erreicht werden kann. Dadurch kann die Einkopplung der Messdaten mit äußerst kleinen Pegeln erfolgen, so dass eine Umgebung und weitere Einrichtungen, beispielsweise zur Datenübertragung über die Energieübertragungsleitung, durch die eingekoppelten Messdaten nicht gestört werden.

Bei einer weiteren Ausführungsform des Verfahrens wird von der Messdatenerfassungsvorrichtung ein Synchronisationssignal zu der Messvorrichtung über die Energieübertragungsleitung übertragen, und die Messdaten werden von der Messvorrichtung in Abhängigkeit von dem Synchronisationssignal auf die Energieübertragungsleitung eingekoppelt. Das Synchronisationssignal kann ebenso wie die Messdaten induktiv, zwischen Schirm und Innenleiter oder über eine Gleichtakteinkopplung von der Messdatenvorrichtung auf die Energieübertragungsleitung eingekoppelt und entsprechend von der Messvorrichtung ausgekoppelt werden. Durch Übertragen des Synchronisationssignals von der Messdatenerfassungsvorrichtung zu der Messvorrichtung wird der Messvorrichtung eine genaue Zeitbasis bereitgestellt, um beispielsweise die Messdaten zeitlich synchronisiert wiederholt auszusenden. Die Messvorrichtung kann sich beispielsweise mit Hilfe eines Phasenregelkreises, eines so genannten Phase Locked Loop (PLL), auf das Synchronisationssignal aufsynchronisieren.

Gemäß einer weiteren Ausführungsform sind mehrere Messvorrichtungen an mehreren Messstellen der Energieübertragungsleitung angeordnet. Von der Messdatenerfassungsvorrichtung wird ein Adressierungssignal, welches eine der mehreren Messvorrichtungen adressiert, zu den mehreren Messvorrichtungen über die Energieübertragungsleitung übertragen. Aufgrund des Adressierungssignals koppelt die adressierte Messvorrichtung die Messdaten auf die Energieübertragungsleitung ein. Das Adressierungssignal kann ebenso wie das Synchronisationssignal von der Messdatenerfassungsvorrichtung beispielsweise induktiv, zwischen Schirm und Innenleiter oder über eine Gleichtakteinkopplung auf die Energieübertragungsleitung eingekoppelt werden. Durch Verwendung des Adressierungssignals, welches eine der mehreren Messvorrichtungen eindeutig identifiziert, können mehrere Messvorrichtungen an mehreren verschiedenen Messstellen der Energieübertragungsleitung angeordnet und von der Messdatenerfassungsvorrichtung abgefragt werden, um Messdaten von den verschiedenen Messstellen der Energieübertragungsleitung zu erfassen. Dadurch kann mit Hilfe des Synchronisationssignals und des Adressierungssignals bei der Verwendung mehrerer Messvorrichtungen an der Energieübertragungsleitung auf einfache Art und Weise eine synchronisierte und geordnete Übertragung der Messdaten von den Messvorrichtungen zu der Messdatenerfassungsvorrichtung sichergestellt werden.

Gemäß einer weiteren Ausführungsform umfasst die Messvorrichtung eine Koppeleinheit zum Einkoppeln der erfassten Messdaten auf die Energieübertragungsleitung und eine weitere Koppeleinheit zur Versorgung der Messvorrichtung mit Energie aus einem elektrischen oder magnetischen Feld der Energieübertragungsleitung. Alternativ kann die Messvorrichtung eine Koppeleinheit umfassen, welche ausgestaltet ist, die erfassten Messdaten auf die Energieübertragungsleitung einzukoppeln und zusätzlich Energie aus dem elektrischen oder magnetischen Feld der Energieübertragungsleitung zur Versorgung der Messvorrichtung bereitzustellen. Dadurch kann die Messvorrichtung auf einfache Art und Weise mit Energie versorgt werden.

Gemäß noch einer weiteren Ausführungsform umfasst die Messvorrichtung eine Koppeleinheit zum Einkoppeln der erfassten Messdaten, welche zusätzlich zur Auskopplung von Teilentladungssignalen ausgestaltet ist. Dadurch kann eine kostengünstige Überwachung von Teilentladungen durchgeführt werden.

Die vorliegende Erfindung wird nachfolgend unter Bezugnahme auf die Zeichnungen anhand bevorzugter Ausführungsformen erläutert werden.
Fig. 1 zeigt schematisch ein System zur Überwachung einer Energieübertragungsleitung gemäß einer Ausführungsform der vorliegenden Erfindung.
Fig. 2 zeigt einen Signalverlauf von auf die Energieübertragungsleitung eingekoppelten Signalen zur Überwachung der Energieübertragungsleitung.

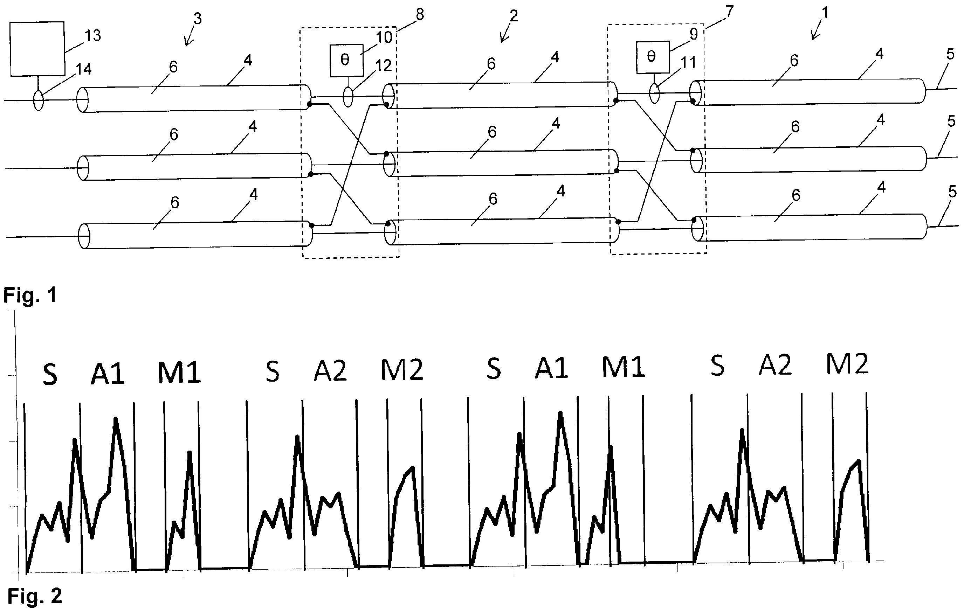

Fig. 1 zeigt drei Leitungsabschnitte 1-3 einer Energieübertragungsleitung. Jeder Leitungsabschnitt 1-3 der Energieübertragungsleitung umfasst jeweils drei Koaxialkabel 4, welche jeweils aus einem Innenleiter 5 und einem Schirm 6 aufgebaut sind. Jeder Leitungsabschnitt 1-3 ist somit zur Übertragung eines dreiphasigen Energiesignals geeignet. Zwischen dem ersten Leitungsabschnitt 1 und dem zweiten Leitungsabschnitt 2 befindet sich ein Auskreuzungsbereich 7, ein so genannter Cross-Bonding-Bereich, in welchem die Schirme 6 der drei Koaxialkabel für die drei Phasen ausgekreuzt werden. In dem Auskreuzungsbereich 7 sind daher die Innenleiter 5 zugänglich. Zwischen dem Leitungsabschnitt 2 und dem Leitungsabschnitt 3 befindet sich ein weiterer Auskreuzungsbereich 8, in welchem ebenfalls die Innenleiter 5 zugänglich sind.

Zur Überwachung der Energieübertragungsleitung sind in den Auskreuzungsbereichen 7, 8 Messvorrichtungen 9 bzw. 10 angeordnet. Die Messvorrichtungen 9, 10 sind beispielsweise ausgestaltet, eine Temperatur θ des Innenleiters 5 zu erfassen oder Teilentladungen innerhalb eines der Koaxialkabel 4 zu erfassen. Die Messvorrichtungen 9, 10 umfassen jeweils eine Einkoppelvorrichtung 11 bzw. 12, welche ausgestaltet ist, ein Messdatensignal, welches beispielsweise eine Temperaturinformation θ oder eine Teilentladungsinformation darstellt, auf den Innenleiter 5 einzukoppeln. Die Einkopplung der Messdaten, wie z.B. der Temperaturinformation θ oder der Teilentladungsinformation, kann beispielsweise induktiv auf den Innenleiter 5 erfolgen. Die Einkopplungsvorrichtung 11 bzw. 12 kann auch dazu verwendet werden, aus dem Magnetfeld des Innenleiters Energie zu gewinnen (engl. energy harvesting) und die Messeinrichtung 9 bzw. 10 damit zu versorgen. Es kann auch eine zweite Kopplungseinrichtung pro Messeinrichtung verwendet werden, wobei eine zur Energiegewinnung und eine zur Messdateneinkopplung verwendet wird. Darüber hinaus kann die Einkopplung der Messdaten auch direkt über eine Spannung zwischen dem Innenleiter 5 und dem Schirm 4 eingekoppelt werden. Weiterhin können die Messdaten auch über eine Gleichtakteinkopplung auf das gesamte Kabel 4 oder auch alle drei Kabel 4 gemeinsam eingekoppelt werden. Letzteres ist insbesondere bei Mittelspannungskabeln interessant, bei denen sich alle drei Phasen in einem gemeinsamen Mantel befinden. An dem in Fig. 1 links gezeigten Ende der Energieübertragungsleitung ist eine Messdatenerfassungsvorrichtung 13 angeordnet, welche über eine Koppeleinheit 14 mit dem Innenleiter 5 von einem der Koaxialkabel 4 verbunden ist. Die in Fig. 1 gezeigte Koppeleinheit 14 ist ausgestaltet, die Messdaten, welche von den Messvorrichtungen 9, 10 auf den Innenleiter 5 eingekoppelt wurden, auszukoppeln und der Messdatenerfassungsvorrichtung 13 bereitzustellen. Die Messdatenerfassungsvorrichtung 13 wertet die Messdaten aus und überwacht auf diese Art und Weise den Zustand der Energieübertragungsleitung.

Um eine geordnete Übertragung der Messdaten von mehreren Messvorrichtungen 9, 10 zu der Messdatenerfassungsvorrichtung 13 sicherzustellen, ist die Messdatenerfassungsvorrichtung 13 ausgestaltet, über die Koppeleinheit 14 ein Synchronisationssignal und ein Adressierungssignal auf den Innenleiter 5 einzukoppeln. Die Messvorrichtungen 9, 10 und ihre Koppeleinheiten 11 bzw. 12 sind ferner derart ausgestaltet, dass sie das Synchronisationssignal und das Adressierungssignal von dem Innenleiter 5 auskoppeln können. Jeder Messvorrichtung 9, 10 ist eine eindeutige Adresse zugeordnet und die Messvorrichtung 9, 10 ist in der Lage, das empfangene Adressierungssignal mit der eigenen Adresse zu vergleichen. Wenn das über den Innenleiter 5 empfangene Adressierungssignal mit der eigenen Adresse übereinstimmt, koppelt die Messvorrichtung 9, 10 ihre Messdaten auf den Innenleiter 5 ein. Mit Hilfe des Synchronisationssignals, auf welches sich die Messvorrichtungen 9, 10 beispielsweise mit Hilfe eines Phasenregelkreises, eines so genannten Phase Locked Loop (PLL) aufsynchronisieren können, wird ein zeitlich geregelter Ablauf für das Übertragen der Adressierungssignale und der Messdaten sichergestellt.

Fig. 2 zeigt beispielhaft, wie eine derartige Synchronisation und Adressierung von beispielsweise zwei Messvorrichtungen 9, 10 abläuft. Fig. 2 zeigt dabei den zeitlichen Signalverlauf, welcher zur Kommunikation zwischen den Messvorrichtungen 9, 10 und der Messdatenerfassungsvorrichtung 13 über die Energieübertragungsleitung übertragen wird. Zunächst koppelt die Messdatenerfassungsvorrichtung 13 ein Synchronisationssignal S auf den Innenleiter 5 ein. Dieses Synchronisationssignal S wird von allen an den Innenleiter 5 angeschlossenen Messvorrichtungen 9, 10 empfangen, wodurch die Messvorrichtungen 9, 10 und die Messdatenerfassungsvorrichtung 13 synchronisiert werden. Dem Synchronisationssignal S folgt ein Adressierungssignal A1. Wie nachfolgend gezeigt werden wird, gibt es verschiedene Adressierungssignale, welche jeweils eine eindeutige Signalform aufweisen, um eine der Messvorrichtungen 9,10 zu adressieren. Das Adressierungssignal A1 hat die eindeutige Signalform zur Adressierung einer ersten Messvorrichtung. Nach einer kurzen Pause vorbestimmter Länge koppelt dann die mit dem Adressierungssignal A1 adressierte Messvorrichtung ihre Messdaten M1 auf den Innenleiter 5 ein. Nach einer weiteren Pause koppelt die Messdatenerfassungsvorrichtung 13 wiederum ein Synchronisationssignal S gefolgt von einem weiteren Adressierungssignal A2 zur Adressierung einer zweiten Messvorrichtung auf den Innenleiter 5 ein. Aufgrund des Empfangs des Adressierungssignals A2 koppelt dann eine zweite Messvorrichtung nach einer Pause vorbestimmter Länge ihre Messdaten M2 auf den Innenleiter 5 ein. Bei einem System mit zwei Messstellen beginnt die Messdatenerfassungsvorrichtung nun wieder bei der ersten Messvorrichtung mit der Adresse A1 und wiederholt den Ablauf wie zuvor beschrieben. Bei den Messstellen wird eine sogenannte Synchrondemodulation, auch kohärente Demodulation, eingesetzt. Dabei ist die Frequenz, mit der die Messdatenerfassungsvorrichtung die Synchronisierimpulse aussendet, den Messstellen sehr genau bekannt. Durch die ständige Wiederholung des Synchronisierimpulses sowie der Adressen können die Messvorrichtungen ihre interne Zeitbasis mittels PLL exakt auf die der Messdatenerfassungsvorrichtung ausrichten und damit Daten mit nahezu beliebig kleinen Amplituden aus dem sehr viel größeren Rauschen herausfiltern, wenn die Daten nur oft genug wiederholt werden.

Um eine fehlerfreie Übertragung der Messdaten M1 und M2 sicherzustellen, werden die Messdaten von der Messvorrichtung 9, 10 mehrfach zu der Messdatenerfassungsvorrichtung 13 übertragen. Dies kann beispielsweise derart erfolgen, dass nach einer Adressierung der entsprechenden Messvorrichtung die Messdaten direkt mehrfach hintereinander zu der Messdatenerfassungsvorrichtung 13 übertragen werden und in der Messdatenerfassungsvorrichtung die mehrfach empfangenen Messdaten überlagert werden, um somit Störungen auszumitteln. Alternativ kann die Messdatenerfassungsvorrichtung auch jede Messvorrichtung mehrfach mit dem im Zusammenhang mit Fig. 2 beschriebenen Adressierungsverfahren adressieren und die entsprechenden Messdaten mehrfach abrufen und durch Überlagerung mitteln, um dadurch eine gute Störunterdrückung zu erreichen. Dadurch ist es möglich, extrem kleine Pegel zur Übertragung der Messdaten zu verwenden.

### BEZUGSZEICHENLISTE

- 1: Leitungsabschnitt
- 2: Leitungsabschnitt
- 3: Leitungsabschnitt
- 4: Koaxialkabel
- 5: Innenleiter
- 6: Schirm
- 7: Auskreuzungsbereich
- 8: Auskreuzungsbereich
- 9: Messvorrichtung
- 10: Messvorrichtung
- 11: Koppeleinheit
- 12: Koppeleinheit
- 13: Messdatenerfassungsvorrichtung
- 14: Koppeleinheit
- A1, A2: Adressierungssignal
- M1, M2: Messdaten
- S: Synchronisationssignal

## Patentansprüche

1. Verfahren zur Überwachung einer Energieübertragungsleitung, umfassend:
- Erfassen von Messdaten (M1, M2) an einer Messstelle (7, 8) der Energieübertragungsleitung (1-3) mit einer Messvorrichtung (9, 10),
- Einkoppeln der erfassten Messdaten (M1, M2) auf die Energieübertragungsleitung (1-3), und
- Übertragen der Messdaten (M1, M2) über die Energieübertragungsleitung (1-3) zu einer Messdatenerfassungsvorrichtung (13), **dadurch gekennzeichnet, dass** die Messdaten (M1, M2) mehrfach wiederholt von der Messvorrichtung (9, 10) zu der Messdatenerfassungsvorrichtung (13) übertragen werden und die mehrfach wiederholten Messdaten (M1, M2) in der Messdatenerfassungsvorrichtung (13) überlagert werden und durch die Überlagerung gemittelte Messdaten bestimmt werden.

2. Verfahren nach Anspruch 1, **dadurch gekennzeichnet, dass** die Energieübertragungsleitung eine Freileitung umfasst und die Messdaten (M1, M2) eine Information über einen Durchhang von Leitern der Freileitung oder über einen Abstand zwischen Leiter und Boden umfassen, wobei der Durchhang oder der Abstand zwischen Leiter und Boden indirekt über eine Kraftmessung einer Leiterspannkraft ermittelt wird.

3. Verfahren nach einem der vorhergehenden Ansprüche, **dadurch gekennzeichnet, dass** die Messdaten (M1, M2) an der Messdatenerfassungsvorrichtung (13) ausgekoppelt werden.

4. Verfahren nach einem der vorhergehenden Ansprüche, **dadurch gekennzeichnet, dass** die Messdaten (M1, M2)
- elektrisch auf die Energieübertragungsleitung (1-3) eingekoppelt werden,
- induktiv auf die Energieübertragungsleitung (1-3) eingekoppelt werden,
- zwischen einem Schirm (6) und einem Innenleiter (5) einer koaxial aufgebauten Energieübertragungsleitung (4) eingekoppelt werden, und/oder
- über einen oder mehrere Schirme und Innenleiter gemeinsam auf die Energieübertragungsleitung (1-3) eingekoppelt werden.

5. System zur Überwachung einer Energieübertragungsleitung, umfassend:
- eine Messdatenerfassungsvorrichtung (13), wobei die Messdatenerfassungsvorrichtung (13) eine Koppeleinheit (14) zum Auskoppeln von an einer Messstelle (7, 8) auf die Energieübertragungsleitung (1-3) eingekoppelten und über die Energieübertragungsleitung (1-3) übertragenen Messdaten (M1, M2) zur Auswertung der Messdaten umfasst, und
- mindestens eine Messvorrichtung (9, 10), wobei die Messvorrichtung (9, 10) eine Messdatenerfassungseinheit zum Erfassen von Messdaten (M1, M2) entlang der Energieübertragungsleitung (1-3) und eine Koppeleinheit (11, 12), welche ausgestaltet ist, die erfassten Messdaten (M1, M2) auf die Energieübertragungsleitung (1-3) einzukoppeln, umfasst,
**dadurch gekennzeichnet,**
**dass** die Messvorrichtung (9, 10) ausgestaltet ist, die Messdaten (M1, M2) mehrfach wiederholt zu der Messdatenerfassungsvorrichtung (13) zu übertragen, wobei die Messdatenerfassungsvorrichtung (13) ausgestaltet ist, die mehrfach wiederholt übertragenen Messdaten (M1, M2) zu überlagern und durch die Überlagerung gemittelte Messdaten zu bestimmen.

6. System nach Anspruch 5, **dadurch gekennzeichnet, dass** die Messdaten (M1, M2) Messgrößen der Energieübertragungsleitung (1-3) umfassen.

7. System nach Anspruch 5 oder 6, **dadurch gekennzeichnet, dass** die Energieübertragungsleitung eine Freileitung umfasst und die Messdaten (M1, M2) eine Information über einen Durchhang von Leitern der Freileitung oder über einen Abstand zwischen Leiter und Boden umfassen.

8. System nach einem der Ansprüche 5-7, **dadurch gekennzeichnet, dass** die Messdaten (M1, M2) eine Temperaturinformation (θ) der Energieübertragungsleitung (1-3) oder eine Teilentladungsinformation der Energieübertragungsleitung (1-3) umfassen.

9. System nach einem der Ansprüche 5-8, **dadurch gekennzeichnet, dass** die Energieübertragungsleitung (1-3) ein Hochspannungskabel, ein Mittelspannungskabel, eine Hochspannungsfreileitung oder eine Mittelspannungsfreileitung umfasst.

## Claims

1. Method for monitoring a power transmission line, comprising:
- acquiring measured data (M1, M2) at a measuring point (7, 8) of the power transmission line (1-3) by means of a measuring device (9, 10);
- coupling-in of the measured data (M1, M2) acquired to the power transmission line (1-3); and
- transmitting the measured data (M1, M2) to a measured data acquisition device (13) via the power transmission line (1-3), **characterised in that** the measured data (M1, M2) are transmitted by the measuring device (9, 10) to the measured data acquisition device (13) in a repeatedly reiterated manner and the repeatedly reiterated measured data (M1, M2) are superimposed in the measured data acquisition device (13) and averaged measured data are determined by the superimposition.

2. Method according to claim 1, **characterised in that** the power transmission line comprises an overhead line and the measured data (M1, M2) comprise an item of information concerning a sag of conductors of the overhead line or concerning a distance between a conductor and the ground, wherein the sag or the distance between the conductor and the ground are indirectly ascertained by a force measurement of a conductor-tensioning force.

3. Method according to any one of the preceding claims, **characterised in that** the measured data (M1, M2) are decoupled at the measured data acquisition device (13).

4. Method according to any one of the preceding claims, **characterised in that** the measured data (M1, M2)
- are electrically coupled in to the power transmission line (1-3);
- are inductively coupled in to the power transmission line (1-3).
- are coupled in between a screen (6) and an internal conductor (5) of a power transmission line (4) of coaxial composition; and/or
- are coupled in to the power transmission line (1-3) via one or a plurality of screens and internal conductors jointly.

5. System for monitoring a power transmission line, comprising:
- a measured data acquisition device (13), the measured data acquisition device (13) comprising a coupling unit (14) for decoupling measured data (M1, M2), which have been coupled in at a measuring point (7, 8) to the power transmission line (1-3) and transmitted via said power transmission line (1-3) for evaluating the measured data; and
- at least one measuring device (9, 10), the measuring device (9, 10) comprising a measured data acquisition unit for acquiring measured data (M1, M2) along the power transmission line (1-3) and a coupling unit (11, 12) which is designed to couple in the measured data (M1, M2) acquired to said power transmission line (1-3),
**characterised in that**
the measuring device (9, 10) is designed to transmit the measured data (M1, M2) to the measured data acquisition device (13) in a repeatedly reiterated manner, wherein the measuring data acquisition device (13) is designed to superimpose the repeatedly reiterated measured data (M1, M2) and to determine averaged measured data by the superimposition.

6. System according to claim 5, **characterised in that** the measured data (M1, M2) comprise measured parameters of the power transmission line (1-3).

7. System according to claim 5 or 6, **characterised in that** the power transmission line comprises an overhead line and the measured data (M1, M2) comprise an item of information concerning a sag of conductors of the overhead line or concerning a distance between a conductor and the ground.

8. System according to any one of claims 5-7, **characterised in that** the measured data (M1, M2) comprise an item of information (θ) regarding a temperature of the power transmission line (1-3) or an item of information regarding a partial discharge of said power transmission line (1-3).

9. System according to any one of claims 5-8, **characterised in that** the power transmission line (1-3) comprises a high voltage cable, a medium voltage cable, a high voltage overhead line or a medium voltage overhead line.

## Revendications

1. Procédé de surveillance d'une ligne de transport d'énergie, comprenant :
- la détection de données de mesure (M1, M2) au niveau d'un point de mesure (7, 8) de la ligne de transport d'énergie (1-3) avec un appareil de mesure (9, 10),
- l'introduction des données de mesure détectées (M1, M2) sur la ligne de transport d'énergie (1-3), et
- la transmission des données de mesure (M1, M2) via la ligne de transport d'énergie (1-3) à un appareil détecteur de données de mesure (13), **caractérisé en ce que** les données de mesure (M1, M2) sont transmises de manière répétée plusieurs fois par l'appareil de mesure (9, 10) à l'appareil détecteur de données de mesure (13) et les données de mesure (M1, M2) répétées plusieurs fois sont superposées dans l'appareil détecteur de données de mesure (13) et des moyennes de données de mesure formées par la superposition sont déterminées.

2. Procédé selon la revendication 1, **caractérisé en ce que** la ligne de transport d'énergie comprend une ligne aérienne et les données de mesure (M1, M2) comprennent une information sur une flèche de conducteurs de la ligne aérienne ou sur une distance entre conducteurs et sol, dans lequel la flèche ou la distance entre conducteurs et sol est déterminée indirectement par l'intermédiaire d'une mesure de force d'un effort de tension de conducteur.

3. Procédé selon l'une quelconque des revendications précédentes, **caractérisé en ce que** les données de mesure (M1, M2) sont extraites au niveau de l'appareil détecteur de données de mesure (13).

4. Procédé selon l'une quelconque des revendications précédentes, **caractérisé en ce que** les données de mesure (M1, M2)
- sont introduites électriquement sur la ligne de transport d'énergie (1-3),
- sont introduites par induction sur la ligne de transport d'énergie (1-3),
- sont introduites entre un blindage (6) et un conducteur interne (5) d'une ligne de transport d'énergie (4) à structure coaxiale, et/ou
- sont introduites par l'intermédiaire d'un ou plusieurs blindages et conducteurs internes conjointement sur la ligne de transport d'énergie (1-3).

5. Système de surveillance d'une ligne de transport d'énergie, comprenant :
- un appareil détecteur de données de mesure (13), dans lequel l'appareil détecteur de données de mesure (13) comprend une unité de couplage (14) destinée à extraire des données de mesure (M1, M2) introduites au niveau d'un point de mesure (7, 8) sur la ligne de transport d'énergie (1-3) et transmises par l'intermédiaire de la ligne de transport d'énergie (1-3) en vue de l'évaluation des données de mesure et
- au moins un appareil de mesure (9, 10), dans lequel l'appareil de mesure (9, 10) comprend une unité détectrice de données de mesure destinée à détecter des données de mesure (M1, M2) le long de la ligne de transport d'énergie (1-3) et une unité de couplage (11, 12) qui est conçue pour introduire les données de mesure détectées (M1, M2) sur la ligne de transport d'énergie (1-3),
**caractérisé en ce que**
l'appareil de mesure (9, 10) est conçu pour transmettre les données de mesure (M1, M2) de manière répétée plusieurs fois à l'appareil détecteur de données de mesure (13), lequel appareil détecteur de données de mesure (13) est conçu pour superposer les données de mesure (M1, M2) transmises de manière répétée plusieurs fois et pour déterminer des moyennes de données de mesure obtenues par la superposition.

6. Système selon la revendication 5, **caractérisé en ce que** les données de mesure (M1, M2) comprennent des grandeurs de mesure de la ligne de transport d'énergie (1-3).

7. Système selon la revendication 5 ou 6, **caractérisé en ce que** la ligne de transport d'énergie comprend une ligne aérienne et les données de mesure (M1, M2) comprennent une information sur une flèche de conducteurs de la ligne aérienne ou sur une distance entre conducteurs et sol.

8. Système selon l'une quelconque des revendications 5-7, **caractérisé en ce que** les données de mesure (M1, M2) comprennent une information de température (θ) de la ligne de transport d'énergie (1-3) ou une information de décharge partielle de la ligne de transport d'énergie (1-3).

9. Système selon l'une quelconque des revendications 5-8, **caractérisé en ce que** la ligne de transport d'énergie (1-3) comprend un câble à haute tension, un câble à moyenne tension, une ligne aérienne à haute tension ou une ligne aérienne à moyenne tension.
